# EUROPEAN PATENT SPECIFICATION

(11) **EP 3 933 937 B1**
(45) Date of publication and mention of the grant of the patent: **01.10.2025**
(21) Application number: 20193299.3
(22) Date of filing: 28.08.2020
(51) Int. Cl.: H10F 19/90, H10F 71/00, H10F 77/14

(54) **PHOTOVOLTAIC MODULE, SOLAR CELL AND METHOD FOR MANUFACTURING THEREOF**
FOTOVOLTAISCHES MODUL, SOLARZELLE UND VERFAHREN ZUR HERSTELLUNG DAVON
MODULE PHOTOVOLTAÏQUE, CELLULE SOLAIRE ET SON PROCÉDÉ DE FABRICATION

(30) Priority: 29.06.2020 CN 202010609849
(43) Date of publication of application: 05.01.2022
(73) Proprietor: JINKO SOLAR CO., LTD., Jiangxi, 334100 (CN)
(72) Inventor: Yang, Jie, Shanghai (CN); Zhang, Xinyu, Shanghai, (CN); Jin, Hao, Shanghai (CN)
(74) Representative: Spachmann, Holger

(56) References cited:
- CN-A- 111 048 609
- JP-A- S6 242 469
- US-A- 3 769 091
- US-A1- 2010 224 230
- US-A1- 2018 076 762
- US-A1- 2019 088 802

## Description

### TECHNICAL FIELD

The present disclosure relates to the technical field of a solar energy and, in particular, to a solar cell, a shingled photovoltaic module and a method for manufacturing the solar cell.

### BACKGROUND

Shingled photovoltaic modules include glass, an upper encapsulating adhesive layer, at least one solar cell string, a lower encapsulating adhesive layer and a back plate along a thickness direction. The solar cell string includes a plurality of solar cells, and adjacent solar cells are electrically connected to each other. Specifically, adjacent solar cells are connected by overlapping to achieve electrical connection, that is, there is an overlapping area and a non-overlapping area between the adjacent solar cells in the thickness direction. Along the thickness direction, a height of the overlapping area differs from a height of the non-overlapping area, that is, in the solar cell string, respective solar cells are located in different planes. In the solar cell string, the arrangement of the overlapping area leads to a relatively small light-receiving area of the solar cell, which leads to reduction in photoelectric conversion efficiency of the shingled photovoltaic module. JP S62 42469 A discloses a solar cell array known from the prior art.

### SUMMARY

The present disclosure provides a solar cell, a shingled photovoltaic module, and a method for manufacturing the solar cell. The shingled photovoltaic module has a larger light-receiving area and a higher photoelectric conversion efficiency.

A first aspect of the present disclosure provides a solar cell, the solar cell includes a body portion; a first extending portion provided at one end of the body portion; and a second extending portion provided at another end of the body portion; wherein a thickness T1 of the body portion is greater than a thickness T2 of the first extending portion, and the thickness T1 of the body portion is greater than a thickness T3 of the second extending portion; the thickness T2 of the first extending portion ranges from 50µm to 200µm, and the thickness T3 of the second extending portion ranges from 50µm to 200µm.

In an embodiment, along a length direction of the solar cell, the first extending portion is provided at one end of the body portion and the second extending portion is provided at the other end of the body portion; and the first extending portion is located above or below the second extending portion in a thickness direction of the solar cell.

In an embodiment, in the length direction of the solar cell, an orthographic projection of the first extending portion does not overlap an orthographic projection of the second extending portion.

In an embodiment, each of the first extending portion and the second extending portion is formed as a cuboid structure.

In an embodiment, the thickness T1 of the body portion ranges from 100µm to 400µm.

A second aspect of the present disclosure provides a shingled photovoltaic module, the shingled photovoltaic module includes a plurality of solar cells described as above arranged along a length direction, and adjacent ones of the plurality of solar cells are electrically connected to each other, the adjacent ones of the plurality of solar cells includes a first solar cell and a second solar cell along the length direction, the first extending portion of the first solar cell and the second extending portion of the second solar cell are arranged along a thickness direction of the solar cell and are electrically connected to each other.

In an embodiment, each of the plurality of solar cells includes an upper end surface and a lower end surface arranged opposite to the upper end surface along the thickness direction; the upper end surface of the first solar cell and the upper end surface of the second solar cell are located in a same plane; and the lower end surface of the first solar cell and the lower end surface of the second solar cell are located in a same plane.

In an embodiment, a sum of a thickness T2 of the first extending portion of the first solar cell and a thickness T3 of the second extending portion of the second solar cell is smaller than or equal to a thickness T1 of the body portion.

In an embodiment, a first connecting portion is provided on an end surface of the first extending portion along the thickness direction, and a second connecting portion is provided on an end surface of the second extending portion along the thickness direction; and in the thickness direction, the first extending portion of the first solar cell and the second extending portion of the second solar cell are electrically connected to each other through the first connecting portion and the second connecting portion.

In an embodiment, along the length direction, the first extending portion of the first solar cell abuts the body portion of the second solar cell, and the second extending portion of the second solar cell abuts the body portion of the first solar cell.

A third aspect of the present disclosure provides a method for manufacturing a solar cell with a silicon substrate having a cubic structure, and the method includes: cutting, according to a plurality of first tracks, one end of the silicon substrate along a second direction, wherein the plurality of first tracks is distributed at first intervals along a first direction of the silicon substrate; cutting, according to a plurality of second tracks, the other end of the silicon substrate along the second direction, wherein the plurality of second tracks is distributed at second intervals along the first direction of the silicon substrate, and the plurality of first tracks and the plurality of second tracks are alternately arranged along the first direction; cutting, according to a plurality of third tracks, the silicon substrate into a plurality of silicon wafers, wherein the plurality of third tracks is distributed at third intervals along the first direction of the silicon substrate, and is each communicated with one of the plurality of first tracks and one of the plurality of second track; and removing redundant silicon material after the cutting, to form a plurality of first notches and a plurality of second notches, wherein each of the plurality of silicon wafers includes one of the plurality of first notches and one of the plurality of second notches, the plurality of silicon wafers is configured to form the plurality of solar cells each including a body portion, a first extending portion and a second extending portion, a distance between adjacent ones of the plurality of third tracks is T1; a dimension of the first notch along the first direction is T1-T2, and a dimension of the second notch along the first direction is T1-T3; and a dimension of T1 ranges from 100µm to 400µm, a dimension of T1-T2 ranges from 50µm to 350µm, and a dimension of T1-T3 ranges from 50µm to 350µm.

In an embodiment, each of the plurality of first tracks and each of the plurality of second tracks has an L-shape, to form the first extending portion and the second extending portion each as a cuboid structure.

In an embodiment, each of the plurality of third tracks extends along the second direction, and the first direction is perpendicular to the second direction.

In an embodiment, the cutting, according to the plurality of first tracks, one end of the silicon substrate along the second direction and the cutting, according to the plurality of second tracks, the other end of the silicon substrate along the second direction include: cutting the silicon substrate by two rows of cutting wires arranged at fourth intervals in the second direction, and cutting the silicon substrate along the plurality of first tracks and the plurality of second tracks.

In the present disclosure, when the solar cell includes the first extending portion and the second extending portion each with a thickness smaller than the thickness of the body portion, the adjacent solar cells can be electrically connected through the first extending portion and the second extending portion, and since the thickness T2 of the first extending portion and the thickness T3 of the second extending portion are both smaller than the thickness T1 of the body portion, there is no need to stack the adjacent solar cells in the thickness direction to achieve electrical connection, thereby avoiding different heights of the solar cells due to the stacking of the adjacent solar cells, and reducing space in the thickness direction occupied by the solar cells after stacking. Moreover, when the adjacent solar cells are electrically connected through the first extending portion and the second extending portion, an area of a light-receiving surface of the solar cell is not decreased (the area of the light-receiving surface is an upper surface of the solar cell), so as to improve photoelectric conversion efficiency of the solar cell, and reduce the number of the solar cells required when the shingled photovoltaic module outputs a current of certain power, thereby saving costs.

It should be understood that the above general description and the following detailed description are only exemplary and cannot limit the present disclosure.

### BRIEF DESCRIPTION OF DRAWINGS

FIG. 1 is a structural schematic diagram of an exemplary solar cell according to an embodiment of the present disclosure;
FIG. 2 is a structural schematic diagram of an exemplary shingled photovoltaic module according to an embodiment of the present disclosure;
FIG. 3 is a structural schematic diagram of an exemplary silicon substrate for manufacturing a solar cell according to an embodiment of the present disclosure;
FIG. 4 is a structural schematic diagram of the silicon substrate in FIG. 3 after being cut along a first track and a second track;
FIG. 5 is a structural schematic diagram of the silicon substrate in FIG. 4 after being cut along a third track; and
FIG. 6 is a structural schematic diagram of the silicon substrate in FIG. 5 with redundant material removed.

### Reference signs:

1-solar cell;
11-first solar cell;
12-second solar cell;
13-body portion;
14-first extending portion;
141-first connecting portion;
15-second extending portion;
151-second connecting portion;
16-first notch;
17-second notch;
18-upper surface;
19-lower surface;
2-silicone substrate;
21-silicon wafer;
S1-first track, S2-second track, S3-third track;
X-length direction, Z-thickness direction, L1-first direction, L2-second direction, L3-third direction.

The accompany drawings here are incorporated into the specification and constitute a part of the specification, show embodiments that conform to the application, and are used together with the specification to explain the principle of the present disclosure.

### DESCRIPTION OF EMBODIMENTS

In order to better understand the technical solutions of the present disclosure, the embodiments of the present disclosure are described in detail below with reference to the accompanying drawings.

It should be noted that the described embodiments are only a part of the embodiments of the present disclosure, rather than all the embodiments. Based on the embodiments in the present disclosure, all other embodiments obtained by those of ordinary skill in the art without creative work shall fall within the protection scope of the present disclosure.

The terms used in the embodiments of the present disclosure are only for the purpose of describing specific embodiments and are not intended to limit the present disclosure. The singular form "a", "an" "said" and "the" used in the embodiments and appended claims of the present disclosure are also intended to represent a plural form thereof, unless the context clearly indicates other meanings.

It should be understood that the term "and/or" used in this article is merely an association relationship describing associated objects. It means that there can be three kinds of relationships, for example, A and/or B, which can mean: A exists alone, A and B exist at the same time, and B exists alone. In addition, the character "/" here generally indicates that the associated objects before and after "/" are in an "or" relationship.

It should be noted that the terminology such as "up", "down", "left", and "right" described in the embodiments of the present disclosure are described from the perspective of the accompanying drawings and should not be understood as a limitation to the embodiments of the present disclosure. In addition, in the context, it should also be understood that when it is mentioned that an element is connected "above" or "below" another element, it can not only be directly connected "above" and "below" another element, but also can be indirectly connected "above" and "below" another element through an intermediate element.

An embodiment of the present disclosure provides a shingled photovoltaic module. The shingled photovoltaic module includes a plurality of solar cells 1 arranged along a length direction X, and adjacent solar cells 1 are electrically connected (such as series connection or parallel connection). The plurality of solar cells 1 can receive solar energy and can convert the solar energy into electric energy, and after the plurality of solar cells 1 are electrically connected, they can output the electrical energy.

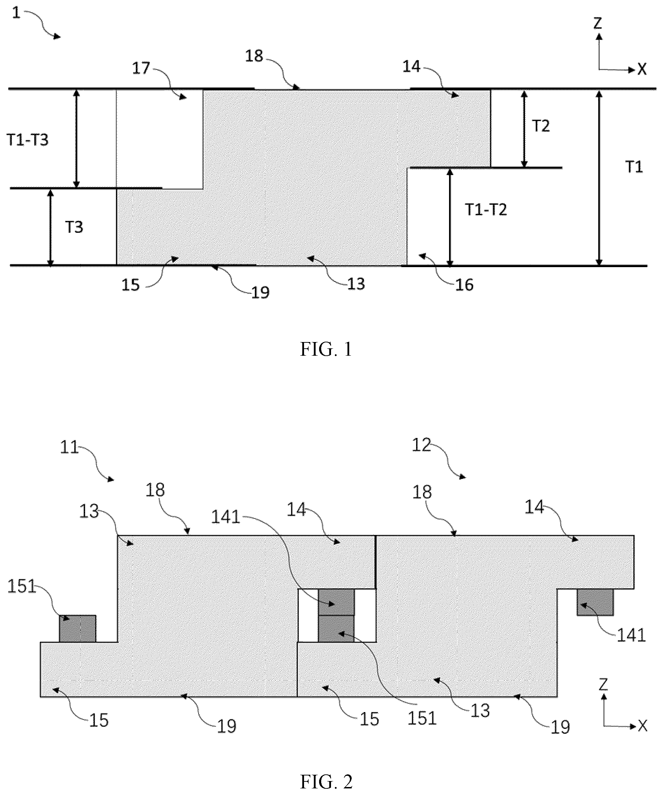

As shown in FIG. 1, the solar cell 1 includes a body portion 13, and two ends of the body portion 13 are respectively provided with a first extending portion 14 and a second extending portion 15. The first extending portion 14 and the second extending portion 15 extend outward relative to the body portion 13, and the first extending portion 14 and the second extending portion 15 of the solar cell 1 are configured to be electrically connected with the adjacent solar cell 1. A thickness T1 of the body portion 13 is greater than a thickness T2 of the first extending portion 14, and the thickness T1 of the body portion 13 is greater than a thickness T3 of the second extending portion 15. Therefore, a first notch 16 is formed between the first extending portion 14 and the body portion 13, and a second notch 17 is formed between the second extending portion 15 and the body portion 13. In some embodiments, as shown in FIG. 1, the first extending portion 14 and the body portion 13 are formed into one piece or fixedly connected, and the second extending portion 15 and the body portion 13 are formed into one piece or fixedly connected.

As shown in FIG. 2, in the shingled photovoltaic module, adjacent solar cells 1 include a first solar cell 11 and a second solar cell 12. The first solar cell 11 includes a body portion 13, and a first extending portion 14 and a second extending portion 15 that are located at two ends of the body portion 13. Similarly, the second solar cell 12 includes a body portion 13, and a first extending portion 14 and a second extending portion 15 that are located at two ends of the body portion 13.

Moreover, as shown in FIG. 1, along the length direction X of the solar cell 1, the first extending portion 14 and the second extending portion 15 are respectively provided at two ends of the body portion 13, and along a thickness direction Z of the solar cell 1, the first extending portion 14 is located above or below the second extending portion 15. In the embodiment shown in FIG. 1, the first extending portion 14 is located above the second extending portion 15, thus in the solar cell 1, the first notch 16 is located below the first extending portion 14, and the second notch 17 is located above the second extending portion 15.

As shown in FIG. 2, in the shingled photovoltaic module, along the thickness direction Z of the solar cell 1, the first extending portion 14 of the first solar cell 11 extends into the second notch 17 of the second solar cell 12, and the second extending portion 15 of the second solar cell 12 extends into the first notch 16 of the first solar cell 11, so that the first extending portion 14 of the first solar cell 11 and the second extending portion 15 of the second solar cell 12 are arranged along the thickness direction Z and are electrically connected.

In the present disclosure, when the solar cell 1 includes the first extending portion 14 and the second extending portion 15 respectively having a thickness smaller than the thickness of the body portion 13, the adjacent solar cells 1 can be electrically connected through the first extending portion 14 and the second extending portion 15, and since the thickness T2 of the first extending portion 14 and the thickness T3 of the second extending portion 15 are both smaller than the thickness T1 of the body portion 13, there is no need to stack the adjacent solar cells 1 in the thickness direction Z to achieve electrical connection, thereby avoiding that heights of the solar cells 1 at various positions are different due to the stacking of the adjacent solar cells 1, and reducing space in the thickness direction Z occupied by the solar cells 1 after stacking. Moreover, when the adjacent solar cells 1 are electrically connected through the first extending portion 14 and the second extending portion 15, an area of a light-receiving surface of the solar cell 1 is not decreased (the area of the light-receiving surface is an upper surface of the solar cell 1), so as to improve photoelectric conversion efficiency of the solar cell 1, and reduce the number of the solar cells 1 required when the shingled photovoltaic module outputs a current of certain power, thereby saving costs.

In an embodiment as shown in FIG. 1, each solar cell 1 has an upper surface 18 and a lower surface 19 arranged opposed to each other along the thickness direction Z. The upper surface 18 is formed by the body portion 13 and the first extending portion 14, and the lower surface 19 is formed by the body portion 13 and the second extending portion 15. As shown in FIG. 2, after the adjacent solar cells 1 are electrically connected, the upper surfaces 18 of the respective solar cells 1 are located in the same plane, and the lower surfaces 19 of the respective solar cells 1 are located in the same plane. It can be understood that the "same plane" can refer to planes with completely equal levels or refer to planes with substantially equal levels.

In the shingled photovoltaic module, when the upper surfaces 18 of the respective solar cells 1 are in the same plane, the area of the light-receiving surface of the solar cell 1 is the same as an area of the upper surface 18, that is, the solar cell 1 has the largest light-receiving surface area, and there is no loss in the light-receiving area of the solar cell 1 in the process of electrical connection between the adjacent solar cells 1, such that the photoelectric conversion efficiency of the solar cell 1 is improved. In addition, during an encapsulating process of the respective solar cells 1, a laminating force in the thickness direction Z is applied to the solar cell 1 through an encapsulating film, and when the upper surfaces 18 of the respective solar cells 1 are in the same plane and the lower surfaces 19 of the respective solar cells 1 are in the same plane, compared with the related art where there is a laminated area between adjacent solar cells 1 (the laminating force firstly acts on the laminated area, resulting in the risk of damage of the laminated area), the laminating force in this embodiment acts on the upper surfaces 18 and the lower surfaces 19 of the respective solar cells 1 during the encapsulating process of the solar cell 1, the laminating force is applied to a relatively large acting area, thereby reducing the risk of damage to the solar cell 1 under the action of the laminating force, and improving structural strength and yield of the shingled photovoltaic module.

As shown in FIGs. 1 and 2, the first extending portion 14 and the second extending portion 15 are both cuboid structures, that is, the first extending portion 14 has a uniform thickness T2, and the second extending portion 15 has a uniform thickness T3. In this case, as shown in FIG. 2, an end surface of the first extending portion 14 in the thickness direction Z is parallel to an end surface of the second extending portion 15 in the thickness direction Z, such that the electrical connection between the two can be easily realized with a high reliability. In addition, when the first extending portion 14 and the second extending portion 15 are both cuboid structures, the structure of the solar cell 1 is simple, making it convenient to process.

In an embodiment as shown in FIG. 1, along the length direction X of the solar cell 1, an orthographic projection of the first extending portion 14 and an orthographic projection of the second extending portion 15 do not overlap. Specifically, along the length direction X of the solar cell 1, a boundary of the orthographic projection of the first extending portion 14 and a boundary of the orthographic projection of the second extending portion 15 overlap, that is, T1=T1 + T2; or, along the length direction X of the solar cell 1, there is a gap between the boundary of the orthographic projection of the first extending portion 14 and the boundary of the orthographic projection of the second extending portion 15, and a size of the gap is T1-T2-T3.

Therefore, as shown in FIG. 2, in the shingled photovoltaic module, a sum of the thickness T2 of the first extending portion 14 of the first solar cell 11 and the thickness T3 of the second extending portion 15 of the second solar cell 12 is smaller than or equal to the thickness T1 of the body portion 13, that is, there is a gap between the connected first extending portion 14 and the second extending portion 15 along the thickness direction Z, and the size of the gap is T1-T2-T3 as mentioned above, in this case, a conductive material can be filled in the gap, so as to realize the electrical connection between the first solar cell 11 and the second solar cell 12.

In an embodiment as shown in FIG. 1, the end surface of the first extending portion 14 along the thickness direction Z is provided with a first connecting portion 141 thereon, and the end surface of the second extending portion 15 along the thickness direction Z is provided with a second connecting portion 151 thereon. As shown in FIG. 2, in the shingled photovoltaic module, the first extending portion 14 of the first solar cell 11 and the second extending portion 15 of the second solar cell 12 are electrically connected through the first connecting portion 141 and the second connecting portion 151.

The first connecting portion 141 and the second connecting portion 151 may be conductive adhesive, such that the first extending portion 14 and the second extending portion 15 are adhered, and since the conductive adhesive can conduct electricity, thereby realizing the electrical connection between the first extending portion 14 and the second extending portion 15; alternatively, the first connecting portion 141 and the second connecting portion 151 may be solder strips, so that the first extending portion 14 and the second extending portion 15 are connected by welding, and since the solder strip can conduct electricity, thereby realizing the electrical connection between the first extending portion 14 and the second extending portion 15.

In addition, when there is a gap between the first extending portion 14 and the second extending portion 15 of the adjacent solar cells 1 along the thickness direction Z (the size of the gap is T1-T2-T3), the first connecting portion 141 and the second connecting portion 151 can fill up the gap, thereby increasing the connection area between the first extending portion 14 and the second extending portion 15 and improving the reliability of the connection between the two (including both mechanical connection reliability and the electrical connection reliability), and when the first connecting portion 141 and the second connecting portion 151 fill up the gap, it is possible to prevent impurities from entering between the first extending portion 14 and the second extending portion 15 of the adjacent solar cells 1 which may affect the electrical connection and the mechanical connection therebetween; alternatively, as shown in FIG. 2, the first connecting portion 141 and the second connecting portion 151 may partially fill the gap between the first extending portion 14 and the second extending portion 15, in this case, while satisfying the connection reliability (including both the mechanical connection reliability and the electrical connection reliability) of the first extending portion 14 and the second extending portion 15, it is also possible to save the materials for the first connecting portion 141 and the second connecting portion 151, thereby reducing costs. In an embodiment as shown in FIG. 2, in the shingled photovoltaic module, along the length direction X, the first extending portion 14 of the first solar cell 11 abuts the body portion 13 of the second solar cell 12, and the second extending portion 15 of the second solar cell 12 abuts the body portion 13 of the first solar cell 11, so that the connection area between the first solar cell 11 and the second solar cell 12 is increased, and thus the reliability of the mechanical connection and the electrical connection is improved.

In addition, the first extending portion 14 of the first solar cell 11 and the body portion 13 of the second solar cell 12 can also be connected by a conductive material (such as conductive adhesive or solder strip), and the second extending portion 14 of the second solar cell 12 and the body portion 13 of the first solar cell 11 may also be connected by the conductive material (such as conductive adhesive or solder strip), thereby further improving the reliability of the mechanical connection and the electrical connection between the first solar cell 11 and the second solar cell 12, and the electrical connection area therebetween is increased, thereby facilitating the current between the first solar cell 11 and the second solar cell 12 to pass through.

In the above embodiments, as shown in FIG. 1, the thickness T2 of the first extending portion 14 ranges from 50µm to 200µm, such as 80µm, 100µm, 150µm, etc., the thickness T3 of the second extending portion 15 ranges from 50µm to 200µm, such as 70µm, 80µm, 100µm, 120µm, etc., and the thickness T1 of the body portion 13 ranges from 100µm to 400µm, such as 120µm, 140µm, 200µm, 300µm, etc. The thickness T2 of the first extending portion 14 and the thickness T3 of the second extending portion 15 may be the same or different, and the thickness T2 of the first extending portion 14 may be greater than or smaller than the thickness T3 of the second extending portion 15, as long as T2<T1 and T3<T1 are satisfied.

In an embodiment, taking the thickness T2 of the first extending portion 14 as an example, if T2 is too small (for example, smaller than 50µm), the structural strength of the first extending portion 14 is relatively low, such that the structural strength of a connecting portion between the adjacent solar cells 1 is relatively low, and there is a risk of failure of the electrical and mechanical connection; if T2 is too large (for example, larger than 200µm), an overall thickness of solar cell 1 will be too large, which increases the space occupied by the solar cell 1 in the thickness direction Z, moreover, when T2 is too large, the material of the first extending portion 14 is much wasted. Similar situations apply to the thickness T3 of the second extending portion 15.

Moreover, if the thickness T1 of the body portion 13 is too small (for example, smaller than 100µm), since the thickness T2 of the first extending portion 14 and the thickness T3 of the second extending portion 15 are both smaller than T1, if T1 is too small, the T2 and T3 will be excessively small, which will in turn decrease the structural strength of the first extending portion 14 and the second extending portion 15, thereby resulting in the risk of failure of the electrical and mechanical connection between the adjacent solar cells 1; if the thickness T1 of the body portion 13 is too large (for example, greater than 400µm), the overall thickness of the solar cell 1 will be excessively large, thereby increasing the space occupied by the solar cell 1 in the thickness direction Z and resulting in more waste of the material of the body portion 13.

Therefore, when T2 and T3 ranges from 50µm to 200µm and T1 ranges from 100µm to 400µm, the solar cell 1 occupies a relatively small space along the thickness direction Z, and the electrical connection and the mechanical connection between the adjacent solar cells 1 are more reliable, thereby improving the yield of the shingled photovoltaic modules.

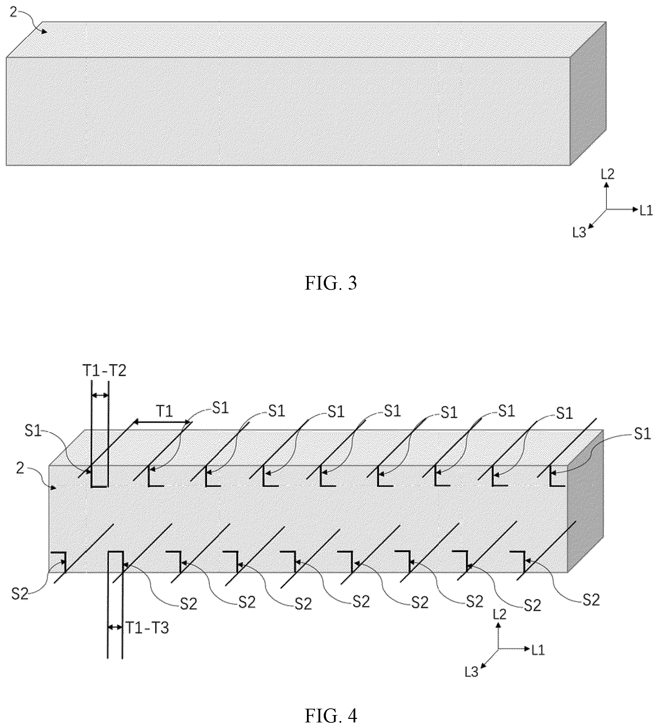

In addition, the present disclosure also provides a method for manufacturing the solar cell 1, and the silicon substrate 2 shown in FIG. 3 can be processed into the solar cell 1 shown in FIG. 1 through the manufacturing method. The silicon substrate 2 may have a cubic structure, and edges of the silicon substrate 2 of the cubic structure may also be chamfered. A first direction L1 of the silicon substrate 2 may be a length direction of the silicon substrate 2, a second direction L2 of the silicon substrate 2 may be a height direction of the silicon substrate 2, and a third direction L3 of the silicon substrate 2 may be a width direction of the silicon substrate 2. The manufacturing method includes following steps:

S1: as shown in FIG. 4, the silicon substrate 2 may be cut according to first tracks S1 from an end of the silicon substrate 2 along the second direction L2. A plurality of first tracks S1 is distributed at first intervals along the first direction L1 of the silicon substrate 2. The silicon substrate 2 may be cut according to second tracks S2 from the other end of the silicon substrate 2 along the second direction L2. A plurality of second tracks S2 is distributed at second intervals along the first direction L1 of the silicon substrate 2. The first tracks S1 and the second tracks S2 are alternately arranged along the first direction L1;

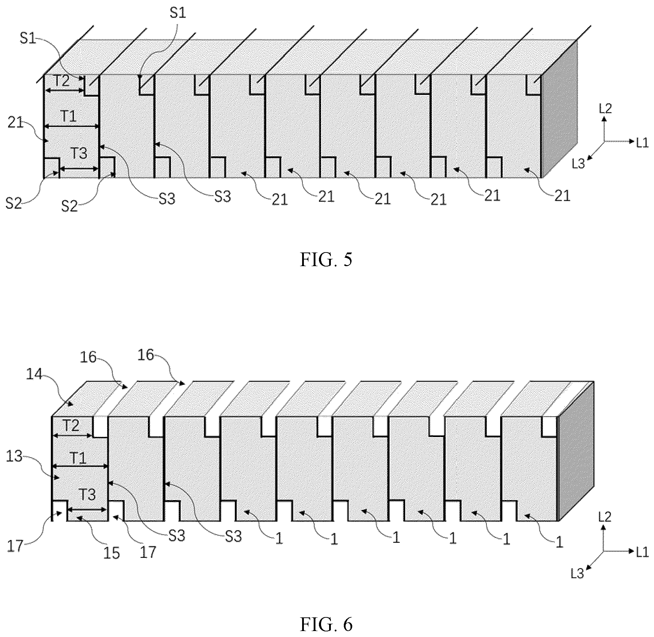

S2: as shown in FIG. 5, the silicon substrate 2 may be cut into a plurality of silicon wafers 21 along third tracks S3. A plurality of third tracks S3 is distributed at third intervals along the first direction L1 of the silicon substrate 2, and the third track S3 is communicated with the first tracks S1 and the second tracks S2;

S3: as shown in FIG. 6, redundant silicon material is removed after the cutting, to form a plurality of first notches 16 and a plurality of second notches 17. The plurality of first notches 16 and the second notches 17 are distributed at fourth intervals along the first direction L1 and alternately arranged along the first direction L1. Each of the silicon wafers 21 includes one of the first notches 16 and one of the second notches 17, and the silicon wafer 21 is used to form the solar cell 1 as shown in FIG. 1.

It should be noted that the above the steps S1 and S2 do not have a strict sequence, that is, the step S2 can be before step S1 or after step S1, there may be other steps between step S1 and step S2, and there may be other steps between S2 and S3 either.

In this embodiment, since the first tracks S1 and the second tracks S2 are alternately arranged along the first direction L1 (the first notches 16 and the second notches 17 are alternately arranged along the first direction L1), after the above three steps, the silicon substrate 2 having the cubic structure can be cut into a plurality of solar cells 1, such that the first extending portions 14 and the second extending portions 15 of the respective solar cells 1 are alternately arranged along the first direction L1 of the silicon substrate 2. After the silicon substrate 2 is processed through the above-mentioned steps, a plurality of solar cells 1 having the same structure can be formed.

In an embodiment, the above step S1 may further include:
S11: the silicon substrate 2 is cut by two rows of cutting wires spaced apart along the second direction L2, and the cutting is performed along the plurality of first tracks S1 and the plurality of second tracks S2.

In this embodiment, when cutting the silicon substrate 2 along the first tracks S1 and the second tracks S2, the cutting simultaneously is performed through the two rows of the cutting wires, thereby reducing cutting processes and allowing the first tracks S1 and the second tracks S2 to synchronously produce incisions, so as to ensure position accuracy of the incision formed along by the first track S1 and the incision formed along by the second track S2, to further ensure position accuracy of the first extending portion 14 and the second extending portion 15 of the formed solar cell 1.

The above-mentioned cutting wire may be a diamond wire or other wires having relatively high hardness and relatively good cutting performance.

In an embodiment as shown in FIG. 4, the first track S1 and the second track S2 are L-shaped, and one side of the L-shaped first track S1 and one side of the L-shaped second track S2 extend along the first direction L1, and the other side thereof extends along the second direction L2, that is, the incision formed by the first track S1 and the incision formed by the second track S2 are perpendicular to each other.

**In** this embodiment, the L-shaped first track S1 and second track S2 can allow both the first extending portion 14 and the second extending portion 15 of the solar cell 1 to obtain a cuboid structure.

**In** another aspect, in the above step S2, as shown in FIG. 5, the third track S3 extends along the second direction L2, and the first direction L1 is perpendicular to the second direction L2.

**In** this embodiment, as shown in FIG. 5, the first track S1 and the third track S3 enclose a cuboid structure, the second track S2 and the third track S3 enclose a cuboid structure, and after the above step S3, the silicon material corresponding to the cuboid structure enclosed by the first track S1 and the third track S3 is removed, the silicon material of the cuboid structure enclosed by the second track S2 and the third track S3 is removed, so as to form the first notch 16 and the second notch 17 of the cuboid structure as shown in FIG. 6.

In addition, the first track S1 penetrates through the silicon substrate 2 along the third direction L3, the second track S2 penetrates through the silicon substrate 2 along the third direction L3, and the first track S1 penetrates through the upper surface of the silicon substrate 2 along the second direction L2, and the second track S2 penetrates through the lower surface of the silicon substrate 2 in the second direction L2. In combination with FIG. 1 and FIG. 6, the first direction L1 of the silicon substrate 2 is the length direction X of the solar cell 1, the second direction L2 of the silicon substrate 2 is the thickness direction Z of the solar cell 1, and the third direction L3 of the silicon substrate 2 is a width direction of the solar cell 1 (not shown in FIG. 1).

Therefore, a dimension of the silicon substrate 2 shown in FIG. 3 along the third direction L3 is the same as the width of the solar cell 1 shown in FIG. 1, and when the two are the same, in the process of cutting the silicon substrate 2, only dimensions of the cutting tracks along the first direction L1 and the second direction L2 need to be considered, there is no need to consider the dimension of the track along the third direction L3, as long as the cutting track penetrates through the silicon substrate 2 along the third direction L3, thereby simplifying the cutting processes. Therefore, when selecting the silicon substrate 2 for manufacturing the solar cell 1, a suitable silicon substrate 2 can be selected according to the width required by the solar cell 1.

In the above embodiments, as shown in FIG. 6, a distance between adjacent third tracks S3 is T1, and a dimension of the first notch 16 along the first direction L1 is T1-T2, that is, a dimension of the first track S1 along the first direction L1 is T1-T2, and a dimension of the second notch 17 along the first direction L1 is T1-T3, that is, a dimension of the second track S2 along the first direction L1 is T1-T3. The dimension of T1 is 100-400µm, the dimension of T1-T2 is 50-350µm, and the dimension of T1-T3 is 50-350µm.

In this embodiment, in the process of cutting along the first track S1 in step S1, the dimension of the first track S1 along the first direction L1 is controlled as T1-T2 (50-350µm), and in the process of cutting along the second track S2 in step S1, the dimension of the second track S2 along the first direction L1 is controlled as T1-T3 (50-350µm). After being cut according to this dimension, a dimension of the first extending portion 14 of the formed solar cell 1 along the first direction L1 is T2 (50-200µm), a dimension of the second extending portion 15 along the first direction L1 is T3 (50-200µm), and a dimension of the body portion 1 along the first direction L1 is T1 (100-400µm).

Therefore, in this embodiment, by controlling the dimensions of the first track S1, the second track S2 and the third track S3, the dimensions of the body portion 13, the first extending portion 14 and the second extending portion 15 of the solar cell 1 formed after cutting can be controlled.

The above descriptions are only some embodiments of the present disclosure and are not intended to limit the present disclosure. For those skilled in the art, the present disclosure can have various modifications and changes. Any modification, equivalent replacement, improvement, etc. made within the principle of the present disclosure shall be included in the protection scope of the present disclosure.

## Claims

1. A solar cell (1), comprising:
a body portion (13);
a first extending portion (14) provided at one end of the body portion (13); and
a second extending portion (15) provided at another end of the body portion (13);
wherein a thickness T1 of the body portion (13) is greater than a thickness T2 of the first extending portion (14), and the thickness T1 of the body portion (13) is greater than a thickness T3 of the second extending portion (15),
the thickness T2 of the first extending portion (14) ranges from 50µm to 200µm; and
the thickness T3 of the second extending portion (15) ranges from 50µm to 200µm.

2. The solar cell (1) according to claim 1, wherein along a length direction (X) of the solar cell (1), the first extending portion (14) is provided at one end of the body portion (13) and the second extending portion (15) is provided at the other end of the body portion (13); and
the first extending portion (14) is located above or below the second extending portion (15) in a thickness direction (Z) of the solar cell (1).

3. The solar cell (1) according to claim 2, wherein in the length direction (X) of the solar cell (1), an orthographic projection of the first extending portion (14) does not overlap an orthographic projection of the second extending portion (15).

4. The solar cell (1) according to claim 1, wherein each of the first extending portion (14) and the second extending portion (15) is formed as a cuboid structure.

5. The solar cell (1) according to claim 1, wherein the thickness T1 of the body portion (13) ranges from 100µm to 400µm.

6. A shingled photovoltaic module, comprising:
a plurality of solar cells (1) according to any one of claims 1 to 5, wherein the plurality of solar cells (1) is arranged along a length direction (X) of the solar cell (1), and adjacent ones of the plurality of solar cells (1) are electrically connected to each other;
wherein the adjacent ones of the plurality of solar cells (1) comprises a first solar cell (11) and a second solar cell (12) along the length direction (X), the first extending portion (14) of the first solar cell (11) and the second extending portion (15) of the second solar cell (12) are arranged along a thickness direction (Z) of the solar cell (1) and are electrically connected to each other.

7. The shingled photovoltaic module according to claim 6, wherein each of the plurality of solar cells (1) comprises an upper end surface (18) and a lower end surface (19) arranged opposite to the upper end surface (18) along the thickness direction (Z);
the upper end surface (18) of the first solar cell (11) and the upper end surface (18) of the second solar cell (12) are located in a same plane; and
the lower end surface (19) of the first solar cell (11) and the lower end surface (19) of the second solar cell (12) are located in a same plane.

8. The shingled photovoltaic module according to claim 6, wherein a sum of a thickness T2 of the first extending portion (14) of the first solar cell (11) and a thickness T3 of the second extending portion (15) of the second solar cell (12) is smaller than or equal to a thickness T1 of the body portion (13).

9. The shingled photovoltaic module according to claim 6, wherein a first connecting portion (141) is provided on an end surface of the first extending portion (14) along the thickness direction (Z), and a second connecting portion (151) is provided on an end surface of the second extending portion (15) along the thickness direction (Z); and
in the thickness direction (Z), the first extending portion (14) of the first solar cell (11) and the second extending portion (15) of the second solar cell (12) are electrically connected to each other through the first connecting portion (141) and the second connecting portion (151).

10. The shingled photovoltaic module according to claim 6, wherein along the length direction (X), the first extending portion (14) of the first solar cell (11) abuts the body portion (13) of the second solar cell (12), and the second extending portion (15) of the second solar cell (12) abuts the body portion (13) of the first solar cell (11).

11. A method for manufacturing a solar cell (1) with a silicon substrate (2) having a cubic structure, comprising:
cutting, according to a plurality of first tracks (S1), one end of the silicon substrate (2) along a second direction (L2), wherein the plurality of first tracks (S1) is distributed at first intervals along a first direction (L1) of the silicon substrate (2);
cutting, according to a plurality of second tracks (S2), the other end of the silicon substrate (2) along the second direction (L2), wherein the plurality of second tracks (S2) is distributed at second intervals along the first direction (L1) of the silicon substrate (2), and the plurality of first tracks (S1) and the plurality of second tracks (S2) are alternately arranged along the first direction (L1);
cutting, according to a plurality of third tracks (S3), the silicon substrate (2) into a plurality of silicon wafers (21), wherein the plurality of third tracks (S3) is distributed at third intervals along the first direction (L1) of the silicon substrate (2), and is each communicated with one of the plurality of first tracks (S1) and one of the plurality of second track (S2); and
removing redundant silicon material after the cutting, to form a plurality of first notches (16) and a plurality of second notches (17), wherein each of the plurality of silicon wafers (21) comprises one of the plurality of first notches (16) and one of the plurality of second notches (17), the plurality of silicon wafers (21) is configured to form the plurality of solar cells (1) each comprising a body portion (13), a first extending portion (14) and a second extending portion (15),
wherein a distance between adjacent ones of the plurality of third tracks (S3) is T1;
a dimension of the first notch (16) along the first direction (L1) is T1-T2, and a dimension of the second notch (17) along the first direction (L1) is T1-T3; and
a dimension of T1 ranges from 100µm to 400µm, a dimension of T1-T2 ranges from 50µm to 350µm, and a dimension of T1-T3 ranges from 50µm to 350µm.

12. The method according to claim 11, wherein each of the plurality of first tracks (S1) and each of the plurality of second tracks (S2) has an L-shape, to form the first extending portion (14) and the second extending portion (15) each as a cuboid structure, and
wherein each of the plurality of third tracks (S3) extends along the second direction (L2), and the first direction (L1) is perpendicular to the second direction (L2).

13. The method according to claim 11, wherein the cutting, according to the plurality of first tracks (S1), one end of the silicon substrate (2) along the second direction (L2) and the cutting, according to the plurality of second tracks (S2), the other end of the silicon substrate (2) along the second direction (L2) comprise:
cutting the silicon substrate (2) by two rows of cutting wires arranged at fourth intervals in the second direction (L2), and cutting the silicon substrate (2) along the plurality of first tracks (S1) and the plurality of second tracks (S2).

## Patentansprüche

1. Solarzelle (1), umfassend:
einen Körperabschnitt (13);
einen an einem Ende des Körperabschnitts (13) vorgesehenen ersten vorstehenden Abschnitt (14); und
einen an einem anderen Ende des Körperabschnitts (13) vorgesehenen zweiten vorstehenden Abschnitt (15);
wobei eine Dicke T1 des Körperabschnitts (13) größer als eine Dicke T2 des ersten vorstehenden Abschnitts (14) und die Dicke T1 des Körperabschnitts (13) größer als eine Dicke T3 des zweiten vorstehenden Abschnitts (15) ist,
die Dicke T2 des ersten vorstehenden Abschnitts (14) in einem Bereich zwischen 50 µm und 200 µm liegt; und
die Dicke T3 des zweiten vorstehenden Abschnitts (15) in einem Bereich zwischen 50 µm und 200 µm liegt.

2. Solarzelle (1) nach Anspruch 1, wobei in Längenrichtung (X) der Solarzelle (1) der erste vorstehende Abschnitt (14) an einem Ende des Körperabschnitts (13) und der zweite vorstehende Abschnitt (15) am anderen Ende des Körperabschnitts (13) vorgesehen ist; und
der erste vorstehende Abschnitt (14) in Dickenrichtung (Z) der Solarzelle (1) über oder unter dem zweiten vorstehenden Abschnitt (15) angeordnet ist.

3. Solarzelle (1) nach Anspruch 2, wobei eine Orthogonalprojektion des ersten vorstehenden Abschnitts (14) in Längenrichtung (X) der Solarzelle (1) eine Orthogonalprojektion des zweiten vorstehenden Abschnitts (15) nicht überlappt.

4. Solarzelle (1) nach Anspruch 1, wobei der erste vorstehende Abschnitt (14) und der zweite vorstehende Abschnitt (15) jeweils als eine Quaderstruktur ausgebildet sind.

5. Solarzelle (1) nach Anspruch 1, wobei die Dicke T1 des Körperabschnitts (13) in einem Bereich zwischen 100 µm und 400 µm liegt.

6. Geschindeltes photovoltaisches Modul, umfassend:
eine Vielzahl von Solarzellen (1) nach einem der Ansprüche 1 bis 5, wobei die Vielzahl von Solarzellen (1) in Längenrichtung (X) der Solarzelle (1) angeordnet ist und zueinander benachbarte Zellen der Vielzahl von Solarzellen (1) elektrisch miteinander verbunden sind;
wobei die zueinander benachbarten Zellen der Vielzahl von Solarzellen (1) in Längenrichtung (X) eine erste Solarzelle (11) sowie eine zweite Solarzelle (12) umfassen und der erste vorstehende Abschnitt (14) der ersten Solarzelle (11) sowie der zweite vorstehende Abschnitt (15) der zweiten Solarzelle (12) entlang der Dickenrichtung (Z) der Solarzelle (1) angeordnet und elektrisch miteinander verbunden sind.

7. Geschindeltes photovoltaisches Modul nach Anspruch 6, wobei jede Zelle der Vielzahl von Solarzellen (1) in Dickenrichtung (Z) eine obere Endfläche (18) sowie eine der oberen Endfläche (18) gegenüberliegende untere Endfläche (19) umfasst;
die obere Endfläche (18) der ersten Solarzelle (11) und die obere Endfläche (18) der zweiten Solarzelle (12) auf derselben Ebene angeordnet sind; und
die untere Endfläche (19) der ersten Solarzelle (11) und die untere Endfläche (19) der zweiten Solarzelle (12) auf derselben Ebene angeordnet sind.

8. Geschindeltes photovoltaisches Modul nach Anspruch 6, wobei die Summe einer Dicke T2 des ersten vorstehenden Abschnitts (14) der ersten Solarzelle (11) und einer Dicke T3 des zweiten vorstehenden Abschnitts (15) der zweiten Solarzelle (12) kleiner als eine oder gleich einer Dicke T1 des Körperabschnittes (13) ist.

9. Geschindeltes photovoltaisches Modul nach Anspruch 6, wobei an einer Endfläche des ersten vorstehenden Abschnitts (14) in Dickenrichtung (Z) ein erstes Verbindungsteil (141) und an einer Endfläche des zweiten vorstehenden Abschnitts (15) in Dickenrichtung (Z) ein zweites Verbindungsteil (151) vorgesehen ist; und
der erste vorstehende Abschnitt (14) der ersten Solarzelle (11) sowie der zweite vorstehende Abschnitt (15) der zweiten Solarzelle (12) in Dickenrichtung (Z) durch das erste Verbindungsteil (141) und das zweite Verbindungsteil (151) elektrisch miteinander verbunden sind.

10. Geschindeltes photovoltaisches Modul nach Anspruch 6, wobei in Längenrichtung (X) der erste vorstehende Abschnitt (14) der ersten Solarzelle (11) an den Körperabschnitt (13) der zweiten Solarzelle (12) und der zweite vorstehende Abschnitt (15) der zweiten Solarzelle (12) an den Körperabschnitt (13) der ersten Solarzelle (11) anliegt.

11. Verfahren zur Herstellung einer Solarzelle (1) mit einem eine kubische Struktur aufweisenden Siliziumsubstrat (2), umfassend:
Schneiden eines Endes des Siliziumsubstrats (2) in einer zweiten Richtung (L2) entsprechend einer Vielzahl erster Tracks (S1), wobei die Vielzahl erster Tracks (S1) des Siliziumsubstrats (2) mit einem ersten Abstand zueinander entlang einer ersten Richtung (L1) verteilt angeordnet sind;
Schneiden des anderen Endes des Siliziumsubstrats (2) entlang der zweiten Richtung (L2) entsprechend einer Vielzahl zweiter Tracks (S2), wobei die Vielzahl zweiter Tracks (S2) mit einem zweiten Abstand zueinander entlang der ersten Richtung (L1) des Siliziumsubstrats (2) verteilt angeordnet sind und die Vielzahl erster Tracks (S1) sowie die Vielzahl zweiter Tracks (S2) entlang der ersten Richtung (L1) jeweils abwechselnd angeordnet sind;
Schneiden des Siliziumsubstrats (2) in eine Vielzahl von Silizium-Wafern (21) entsprechend einer Vielzahl dritter Tracks (S3), wobei die Vielzahl dritter Tracks (S3) jeweils mit einem dritten Abstand zueinander entlang der ersten Richtung (L1) des Siliziumsubstrats (2) verteilt angeordnet sind und jeder dritte Track (S3) mit einem Track der Vielzahl erster Tracks (S1) sowie einem Track der Vielzahl zweiter Tracks (S2) verbunden ist; und
Entfernen überschüssigen Siliziummaterials nach dem Schneiden, sodass eine Vielzahl erster Kerben (16) sowie eine Vielzahl zweiter Kerben (17) gebildet wird, wobei jeder Wafer der Vielzahl von Silizium-Wafern (21) eine Kerbe der Vielzahl erster Kerben (16) sowie eine Kerbe der Vielzahl zweiter Kerben (17) umfasst und die Vielzahl von Silizium-Wafern (21) dazu ausgelegt ist, die Vielzahl von jeweils einen Körperabschnitt (13), einen ersten vorstehenden Abschnitt (14) sowie einen zweiten vorstehenden Abschnitt (15) umfassenden Solarzellen (1) zu bilden,
wobei ein Abstand zwischen benachbarten Tracks der Vielzahl dritter Tracks (S3) T1 beträgt;
eine Abmessung der ersten Kerbe (16) in erster Richtung (L1) T1-T2 und eine Abmessung der zweiten Kerbe (17) in erster Richtung (L1) T1-T3 betragen; und
eine Abmessung von T1 in einem Bereich zwischen 100 µm und 400 µm, eine Abmessung von T1-T2 in einem Bereich zwischen 50 µm und 350 µm und eine Abmessung von T1-T3 in einem Bereich zwischen 50 µm und 350 µm liegt.

12. Verfahren nach Anspruch 11, wobei jeder Track der Vielzahl erster Tracks (S1) sowie jeder Track der Vielzahl zweiter Tracks (S2) eine L-Form derart aufweist, dass der erste vorstehende Abschnitt (14) sowie der zweite vorstehende Abschnitt (15) mit jeweils einer Quaderstruktur gebildet werden und
wobei sich jeder Track der Vielzahl dritter Tracks (S3) in der zweiten Richtung (L2) erstrecken und die erste Richtung (L1) senkrecht zur zweiten Richtung (L2) ist.

13. Verfahren nach Anspruch 11, wobei das Schneiden eines Endes des Siliziumsubstrats (2) in zweiter Richtung (L2) entsprechend einer Vielzahl erster Tracks (S1) sowie das Schneiden des anderen Endes des Siliziumsubstrats (2) in zweiter Richtung (L2) entsprechend einer Vielzahl zweiter Tracks (S2) Folgendes umfasst:
Schneiden des Siliziumsubstrats (2) in der zweiten Richtung (L2) mithilfe von zwei in einem vierten Abstand zueinander angeordneten Reihen von Schneiddrähten sowie Schneiden des Siliziumsubstrats (2) entlang der Vielzahl erster Tracks (S1) und der Vielzahl zweiter Tracks (S2).

## Revendications

1. Cellule solaire (1), comprenant :
une partie de corps (13) ;
une première partie d'extension (14) ménagée à une extrémité de la partie de corps (13) ; et
une seconde partie d'extension (15) ménagée à une autre extrémité de la partie de corps (13) ;
dans laquelle une épaisseur T1 de la partie de corps (13) est supérieure à une épaisseur T2 de la première partie d'extension (14), et l'épaisseur T1 de la partie de corps (13) est supérieure à une épaisseur T3 de la seconde partie d'extension (15),
l'épaisseur T2 de la première partie d'extension (14) est comprise entre 50 µm et 200 µm ; et
l'épaisseur T3 de la seconde partie d'extension (15) est comprise entre 50 µm et 200 µm.

2. Cellule solaire (1) selon la revendication 1, dans laquelle, dans un sens de la longueur (X) de la cellule solaire (1), la première partie d'extension (14) est ménagée à une extrémité de la partie de corps (13) et la seconde partie d'extension (15) est ménagée à l'autre extrémité de la partie de corps (13) ; et
la première partie d'extension (14) est située au-dessus ou au-dessous de la seconde partie d'extension (15) dans un sens de l'épaisseur (Z) de la cellule solaire (1).

3. Cellule solaire (1) selon la revendication 2, dans laquelle, dans le sens de la longueur (X) de la cellule solaire (1), une projection orthographique de la première partie d'extension (14) ne chevauche pas une projection orthographique de la seconde partie d'extension (15).

4. Cellule solaire (1) selon la revendication 1, dans laquelle chacune de la première partie d'extension (14) et de la seconde partie d'extension (15) a la forme d'une structure cuboïde.

5. Cellule solaire (1) selon la revendication 1, dans laquelle l'épaisseur T1 de la partie de corps (13) est comprise entre 100 µm et 400 µm.

6. Module photovoltaïque en bardeaux, comprenant :
une pluralité de cellules solaires (1) selon l'une quelconque des revendications 1 à 5, dans lequel la pluralité de cellules solaires (1) est disposée dans un sens de la longueur (X) de la cellule solaire (1), et des cellules adjacentes de la pluralité de cellules solaires (1) sont électriquement connectées les unes aux autres ;
dans lequel les cellules adjacentes de la pluralité de cellules solaires (1) comprennent une première cellule solaire (11) et une seconde cellule solaire (12) dans le sens de la longueur (X), la première partie d'extension (14) de la première cellule solaire (11) et la seconde partie d'extension (15) de la seconde cellule solaire (12) sont disposées dans un sens de l'épaisseur (Z) de la cellule solaire (1) et sont électriquement connectées l'une à l'autre.

7. Module photovoltaïque en bardeaux selon la revendication 6, dans lequel chacune de la pluralité de cellules solaires (1) comprend une surface d'extrémité supérieure (18) et une surface d'extrémité inférieure (19) disposée à l'opposé de la surface d'extrémité supérieure (18) dans le sens de l'épaisseur (Z) ;
la surface d'extrémité supérieure (18) de la première cellule solaire (11) et la surface d'extrémité supérieure (18) de la seconde cellule solaire (12) sont situées dans un même plan ; et
la surface d'extrémité inférieure (19) de la première cellule solaire (11) et la surface d'extrémité inférieure (19) de la seconde cellule solaire (12) sont situées dans un même plan.

8. Module photovoltaïque en bardeaux selon la revendication 6, dans lequel une somme d'une épaisseur T2 de la première partie d'extension (14) de la première cellule solaire (11) et d'une épaisseur T3 de la seconde partie d'extension (15) de la seconde cellule solaire (12) est inférieure ou égale à une épaisseur T1 de la partie de corps (13).

9. Module photovoltaïque en bardeaux selon la revendication 6, dans lequel une première partie de connexion (141) est ménagée sur une surface d'extrémité de la première partie d'extension (14) dans le sens de l'épaisseur (Z), et une seconde partie de connexion (151) est ménagée sur une surface d'extrémité de la seconde partie d'extension (15) dans le sens de l'épaisseur (Z) ; et
dans le sens de l'épaisseur (Z), la première partie d'extension (14) de la première cellule solaire (11) et la seconde partie d'extension (15) de la seconde cellule solaire (12) sont électriquement connectées l'une à l'autre par l'intermédiaire de la première partie de connexion (141) et de la seconde partie de connexion (151).

10. Module photovoltaïque en bardeaux selon la revendication 6, dans lequel, dans le sens de la longueur (X), la première partie d'extension (14) de la première cellule solaire (11) vient en butée contre la partie de corps (13) de la seconde cellule solaire (12), et la seconde partie d'extension (15) de la seconde cellule solaire (12) vient en butée contre la partie de corps (13) de la première cellule solaire (11).

11. Procédé de fabrication d'une cellule solaire (1) avec un substrat de silicium (2) ayant une structure cubique, comprenant les étapes consistant à :
découper, suivant une pluralité de premières traces (S1), une extrémité du substrat de silicium (2) dans une deuxième direction (L2), la pluralité de premières traces (S1) étant réparties à des premiers intervalles dans une première direction (L1) du substrat de silicium (2) ;
découper, suivant une pluralité de deuxièmes traces (S2), l'autre extrémité du substrat de silicium (2) dans la deuxième direction (L2), la pluralité de deuxièmes traces (S2) étant réparties à des deuxièmes intervalles dans la première direction (L1) du substrat de silicium (2), et la pluralité de premières traces (S1) et la pluralité de deuxièmes traces (S2) étant disposées alternativement dans la première direction (L1) ;
découper, suivant une pluralité de troisièmes traces (S3), le substrat de silicium (2) en une pluralité de tranches de silicium (21), la pluralité de troisièmes traces (S3) étant réparties à des troisièmes intervalles dans la première direction (L1) du substrat de silicium (2), et communiquant chacune avec l'une de la pluralité de premières traces (S1) et l'une de la pluralité de deuxièmes traces (S2) ; et
enlever le matériau de silicium redondant après la découpe, pour former une pluralité de premières encoches (16) et une pluralité de deuxièmes encoches (17), chacune de la pluralité de tranches de silicium (21) comprenant une de la pluralité de premières encoches (16) et une de la pluralité de deuxièmes encoches (17), la pluralité de tranches de silicium (21) étant configurées pour former la pluralité de cellules solaires (1) comprenant chacune une partie de corps (13), une première partie d'extension (14) et une seconde partie d'extension (15),
dans lequel une distance entre des traces adjacentes de la pluralité de troisièmes traces (S3) est T1 ;
une dimension de la première encoche (16) dans la première direction (L1) est T1-T2, et une dimension de la deuxième encoche (17) dans la première direction (L1) est T1-T3 ; et
une dimension de T1 est comprise entre 100 µm et 400 µm, une dimension de T1-T2 est comprise entre 50 µm et 350 µm et une dimension de T1-T3 est comprise entre 50 µm et 350 µm.

12. Procédé selon la revendication 11, dans lequel chacune de la pluralité de premières traces (S1) et chacune de la pluralité de deuxièmes traces (S2) a une forme de L, pour former la première partie d'extension (14) et la seconde partie d'extension (15) chacune sous la forme d'une structure cuboïde, et
dans lequel chacune de la pluralité de troisièmes traces (S3) s'étend dans la deuxième direction (L2), et la première direction (L1) est perpendiculaire à la deuxième direction (L2).

13. Procédé selon la revendication 11, dans lequel la découpe, suivant la pluralité de premières traces (S1), d'une extrémité du substrat de silicium (2) dans la deuxième direction (L2) et la découpe, suivant la pluralité de deuxièmes traces (S2), de l'autre extrémité du substrat de silicium (2) dans la deuxième direction (L2) consistent à :
découper le substrat de silicium (2) par deux rangées de fils de coupe disposées à des quatrièmes intervalles dans la deuxième direction (L2), et découper le substrat de silicium (2) le long de la pluralité de premières traces (S1) et de la pluralité de deuxièmes traces (S2).
